Europäisches Patentamt

European Patent Office

Office européen des brevets

(11) Publication number: **0 258 665 B1**

(19)

# EUROPEAN PATENT SPECIFICATION

(45) Date of publication of patent specification: **19.11.92**

(21) Application number: **87111277.7**

(22) Date of filing: **04.08.87**

(51) Int. Cl.⁵: **H01S  3/133**, H01S 3/085, H01S 3/06

(54) **Semiconductor laser device.**

(30) Priority: **03.09.86 JP 205993/86**

(43) Date of publication of application:
**09.03.88 Bulletin  88/10**

(45) Publication of the grant of the patent:
**19.11.92 Bulletin  92/47**

(84) Designated Contracting States:
**DE FR GB**

(56) References cited:
**EP-A- 0 117 734**
**EP-A- 0 213 965**

**APPLIED PHYSICS LETTERS, vol. 47, no. 10, 15th November 1985, pages 1036-1038, American Institute of Physics, Woodbury, New York, US; T. YANAGAWA et al.: "Frequency stabilization of an InGaAsP distributed feedback laser to an NH3 absorption line at 15137 A with an external frequency modulator"**

**PATENT ABSTRACTS OF JAPAN, vol. 6, no. 32 (E-96)[910], 26th February 1982; & JP-A-56 150 885**

(73) Proprietor: **HITACHI, LTD.**
**6, Kanda Surugadai 4-chome**
**Chiyoda-ku, Tokyo 101(JP)**

(72) Inventor: **Sakano, Shinji**
**E403 Hitachi-Koyasudai-Apartment 2-32,**
**Koyasu-cho**
**Hachiouji-shi Tokyo(JP)**
Inventor: **Tsuji, Shinji**
**A104 Hitachi-Koyasudai-Apartment 2-32,**
**Koyasu-cho**
**Hachiouji-shi Tokyo(JP)**
Inventor: **Ohishi, Akio**
**117 Kamiigusa-Green-Heights 2-17-19,**
**Kamiigusa**
**Suginami-ku Tokyo(JP)**
Inventor: **Inoue, Hiroaki**
**E102 Hitachi-Koyasudai-Apartment 2-32,**
**Koyasu-cho**
**Hachiouji-shi Tokyo(JP)**
Inventor: **Hirao, Motohisa**
**2-2-6, Ogikubo Suginami-ku**
**Tokyo(JP)**

Inventor: **Matsumura, Hiroyoshi**
**1-38-9, Musashi-dai Hidaka-machi**
**Iruma-gun Saitama-ken(JP)**

(74) Representative: **Strehl, Schübel-Hopf, Groen-**
**ing**
**Maximilianstrasse 54 Postfach 22 14 55**
**W-8000 München 22(DE)**

## Description

BACKGROUND OF THE INVENTION

1. Field of the Invention

The present invention relates to a coherent light source for optical communication, optical information processing, and a coherent light source for an optical sensor and, more particularly, to stabilization of a narrow spectral line width of a semiconductor laser equipped with an external cavity.

2. Description of the Related Art

When a part of an output is fed back to a semiconductor laser, a spectral line width of the semiconductor laser becomes narrower in correspondence with the time delay for the feedback. A semiconductor laser which utilizes this phenomenon, namely, a semiconductor laser with a narrowed spectral line consisting of a semiconductor laser and an external cavity monolithically provided on an InP substrate is reported in Electronics, Letters, Vol. 21, No. 9 (1985) pp 374 to 376.

In this semiconductor laser, since the optical length of the external cavity is fixed, a narrow spectral line width was obtained merely at a discrete laser driven current point, namely, at a discrete wavelength.

The preamble of claim 1 corresponds to EP-A-0 117 734.

SUMMARY OF THE INVENTION

Accordingly, it is an object of the present invention to eliminate the above-described problems in the prior art and to provide an improved semiconductor laser device. More particularly, it is an object of the present invention to secure a stable narrow spectral line width state at a given wavelength in the range of a wavelength which allows a semiconductor laser to oscillate, without the need for temperature control for which control of a narrow spectral line width is troublesome.

It is another object of the present invention to provide a semiconductor laser device having a high coherency.

It is still another object of the present invention to provide a semiconductor laser device which is capable of oscillating a narrow spectral line width state at a given wavelength.

To achieve this aim, a semiconductor laser device according to the present invention as claimed in claim 1 adopts a structure in which a part of laser light output power is received and the optical length of an external cavity is so controlled as to make the light output power constant in order to satisfy the conditions for a narrow spectrum in the case of electrically or mechanically changing the optical length of the external cavity .

Control of the optical length can be achieved by composing the external cavity of a transparent material having a refractive index which can change in accordance with electric field, current or light.

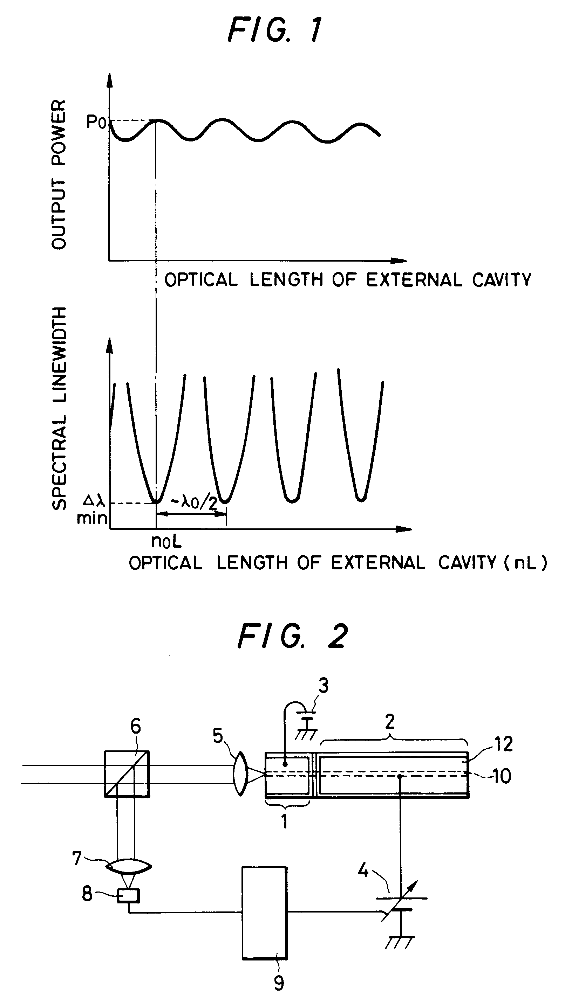

After the temperatures of a semiconductor laser and the driving current are set so as to obtain a desired oscillation wavelength, if the optical length of the external cavity is varied, the light output power and the spectral length width are also varied as shown in Fig. 1. A method of monitoring the oscillation wavelength or the spectral line width is generally troublesome, because it requires a Fabri-Perot etalon or a diffraction grating. On the other hand, it is easier to control the light output power, and it is understood from Fig. 1 that the optical length of the external cavity can be so controlled that the light output power is constant at the maximum value. In particular, if a microsignal is applied to the external cavity portion to detect the differentiated light output power and negatively feed it back in an electric circuit so that the light output power is maximum, a narrow spectral state is obtained at a given light output power or oscillation wavelength. In other words, in Fig. 1, where the optical length of the external cavity is $n_0 L$, wherein $n_0$ representsthe refractive index of the external cavity, and L the length thereof, the narrowest spectral line width of $\Delta \lambda$ mm is obtained. The light output power at this time is $P_0$, and the wavelength is $\lambda_0$. If the light output power changes from $P_0$, the length of the external cavity is adjusted so as to compensate for the change. More specifically, a microsignal is applied to the current applied to the external cavity so as to change the optical length of the external cavity in a range in which the spectral line width is not extremely enlarged. By monitoring the light output power at this time, the microinput signal is multiplied by the monitor signal and the product is integrated. The value obtained provides the differentiated value of the light output power. If the differentiated value of the light output power is fed back so that the refractive index n of the external cavity decreases, the light output power becomes stable at its maximum value, whereby the narrowest spectral line width is stably obtained. If the amplitude of the microsignal takes a sufficiently small value, there is no danger of taking the maximum value of the adjacent light output power, but is fixed at the maximum value of the light output power which should be properly set, so that it is possible to operate the laser at a stable and narrow spectral line width.

The above and other objects, features and advantages of the present invention will become clear from the following description of embodiments, taken in conjunction with the accompanying drawings.

BRIEF DESCRIPTION OF THE DRAWINGS

Fig. 1 shows the relationship between the spectral line width and the light output power in the case where the optical length of the external cavity is varied;
Fig. 2 shows an embodiment of a semiconductor laser device in which the optical length of the external cavity is changed so that the light output power is constant;
Fig. 3 shows an example of control of the optical length of the external cavity using a differential signal;
Fig. 4 shows an embodiment of a semiconductor laser with a light receiver provided on the external cavity side;
Figs. 5(a) and 5(b) show an embodiment of the invention, using a device having a different structure of electrodes;
Fig. 6 shows, as an embodiment of the invention, a semiconductor laser device having an external cavity monolithically provided with the semiconductor laser;
Fig. 7 shows an example of a phase control means used in the embodiment shown in Fig. 1; and
Fig. 8 shows another example of a phase control means.

DESCRIPTION OF THE PREFERRED EMBODIMENTS

The present invention will be explained hereinunder with reference to the accompanying drawings.

Embodiments 1 to 3 are useful for understanding the invention.

Embodiments 4 and 5 fall under the invention as claimed.

Embodiment 1

Referring first to Fig. 2, a known semiconductor laser 1 formed on an InP substrate and an external cavity 2 having a length of 7 mm and a width of 6 $\mu$m of a LiNbO$_3$ single crystal have an optical waveguide 10 which optically couples each other. The optical length of the external cavity 2 can be varied by applying a voltage from a variable power source 4 (0 to 5 V). The light reflected at the end surface of the external cavity 2 is fed back to the semiconductor laser 1 to which a constant current is applied by a constant current power source 3, and the spectral line width is narrowed at an appropriate phase. The light emitted from the semiconductor laser 1 is converged by a lens 5, and thereafter a part of it is separated by a beam splitter 6 and reaches a light receiving element 8 through a lens 7. The signal of the light receiving element 8 is compared with the set output $P_0$ shown Fig. 1 by a phase controlling means 9, and the difference is fed back to the power source 4 of the external cavity to adjust the optical length of the external cavity 2 to the optical length $n_0 L$ at which the signal takes the value of the set output $P_0$ of the semiconductor 1. To state this more concretely, an electric circuit which applies a microsignal current to a current control circuit which controls the current to be applied to the external cavity 2 is added, and the phase controlling means 9 calculates the microsignal and a light output power signal receiving current which receives the light output power varied by the microsignal current to obtain the differentiated value of the light output power. The current applied to the external cavity 2 is so controlled that when the differentiated value is positive, the refractive index n of the external cavity 2 increases, while when it is negative, the refractive index n of the external cavity 2 decreases. In this manner, the differential signal constantly takes the value 0, whereby the light output power takes the maximum value and is stabilized.

In this way, it is possible to obtain a stable and narrow spectral line width by constantly adjusting the optical length to $n_0 L$.

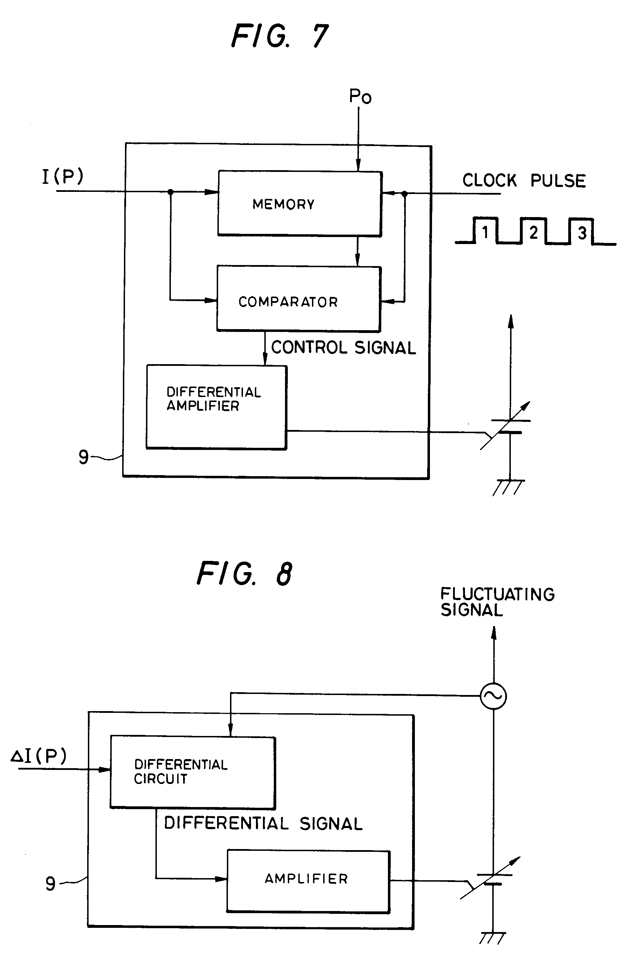

An example of the operation of the phase controlling means 9 is shown in Fig. 7.

When the monitor light output power current (I)P is shifted with respect to the set value ($P_0$) of the light output power obtained by the narrowest spectrum of the laser light, they are compared by a comparator and differentially amplified at a clock signal 1. Simultaneously, at the clock signal 1, the light output power current is stored. The light output power which has been subjected to differential amplification at a clock signal 2 is detected and compared with the value stored at the clock 1. If the light output power at this time still deviates from the set value, a control signal having a polarity opposite to the control signal supplied at the clock signal 1 is differentially amplified at a clock signal 3, thereby obtaining the value corresponding to $P_0$.

Embodiment 2

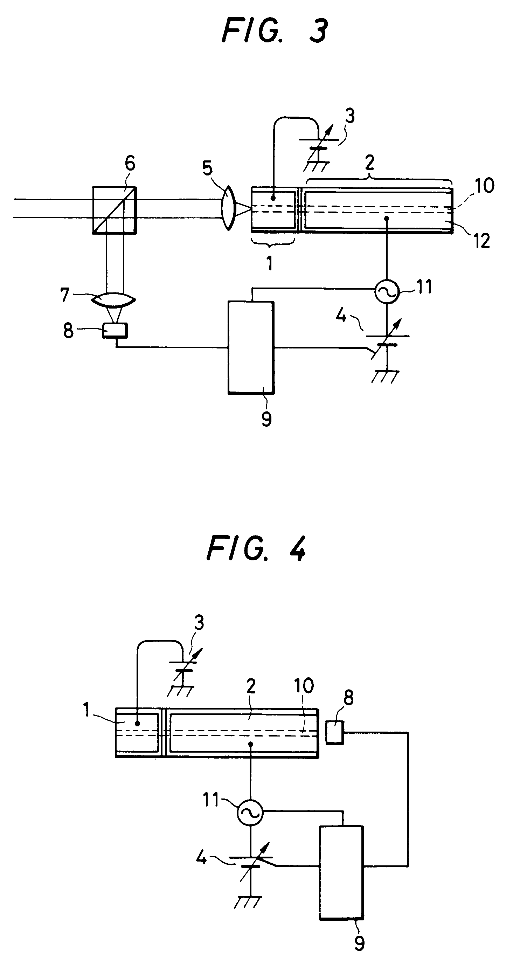

Another embodiment will be explained with reference to Fig. 3.

The fundamental structure of this embodiment is the same as that of Embodiment 1, but a power source 11 is added so that a micro-fluctuating signal is applied to the external cavity 2. The differentiated output which is varied by the micro-fluctuating signal is received by the light receiving element 8, and the phase controlling means 9 adjusts the input to the DC power source 4 so that the ratio of the differentiated output and the total output is constant. Thus, it is possible to obtain a narrow spectrum line width at a given wavelength and output. In this case, when a current is applied to the external cavity 2, the refractive index is reduced.

The operation of the phase controlling means 9 used in this embodiment will be explained with reference to Fig. 8. A differential circuit detects the fluctuating signal and the monitor light output power current $\Delta I(P)$ which responds thereto, and multiplies them to obtain a differential signal. An amplifier amplifies the differential signal and feeds it back to the external cavity 2, thereby stabilizing the light output power at $P_0$.

Embodiment 3

Still another embodiment will be explained with reference to Fig. 4.

The light receiving element 8 is disposed in front of the semiconductor laser 1 in Embodiments 1 and 2, but in this embodiment, it was directly connected to the output end of the external cavity 2 and a similar effect was obtained.

The light receiving element 8 may also be monolithically provided with the semiconductor laser 1 and the external cavity 2 to obtain a similar effect.

Embodiment 4

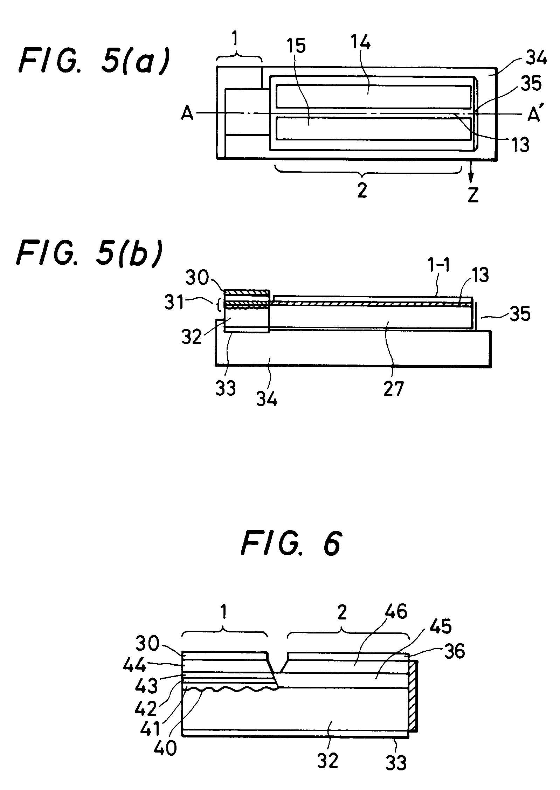

In this embodiment, the semiconductor laser 1, the external cavity 2 used in Embodiment 1 are formed into a hybrid device on a fixed bed 34 having the structure shown in Figs. 5(a) and 5(b).

The element was fabricated in the following procedure.

Fig. 5(a) is a plan view of the device and Fig. 5(b) is a sectional view of the device shown in Fig. 5(a), taken along the line A - A'. P, N electrodes 30 and 33 with a multiple layered film 31 containing an active layer embedded therein were formed on an InP substrate 32 to constitute the DFB (distributed feedback) laser 1 having an oscillation wavelength of 1.55 μm. The external cavity 2 was fabricated by forming an optical waveguide 13 by diffusing Ti on a LiNbO₃ substrate 27 which has been cut in the direction indicated by the symbol Z in Fig. 5(a) and providing electric field applying electrodes 14 and 15 on both sides of the optical waveguide 13. The laser 1 and the external cavity 2 were fixed on a fixed bed 34 such that the output of the laser 1 was supplied to the optical waveguide 13. The external cavity 2 had a width of 6 μm and a length of 7 mm and a reflection coat 35 of Au is formed on the end surface thereof. When the inter-electrode voltage of the external cavity 2 was varied from 0 to 3 V while fixing the magnitude of the driving current of the DFB laser at twice times that of the threshold current, a change in the output and the spectral line width with changes in the phase of the return light were observed.

This device was connected and operated in the same way as in Example 1, and the same effect as that of Example 1 was obtained.

Embodiment 5

This embodiment uses a device having the section shown in Fig. 6.

The device was fabricated in the following procedure.

A diffraction grating 40 having a period of 234 nm was first formed on the N type InP substrate 32. An InGaAsP layer 41 having a band gap wavelength $\lambda s = 1.3$ μm, an InGaAsP layer (active layer) 42 of $\lambda s = 1.53$ μm, an InGaAsP layer 43 of $\lambda s = 1.3$ μm, and a P type InP layer 44 were laminated on the diffraction grating 40 by liquid phase epitaxy to obtain the DFB laser 1. The growth layer in the domain situated at the external cavity 2 was next removed by selective etching. Thereafter, an optical waveguide layer 45 ($\lambda s = 1.3$ μm) and a P type InP layer 46 were laminated in the domain by liquid phase epitaxy. The growth layers were then removed so that mesa-stripes of about 1 μm wide might be formed extending over the two domains 1 and 2. Thereafter, P type, N type and P type InP layers were grown as the current block layers and the clad layer of an index waveguide. The laminate was then etched except for the optical waveguide layer 45 to electrically separate the laser 1 from the external cavity 2. An SiO₂ layer was laid over the laminate and an opening was formed in a current flowing domain to deposit the P electrode 30 therethrough. After the N electrode 33 was deposited on the back surface, an insulating SiO₂ was laid on the end surface of the external cavity 2 and reflecting Au was deposited thereon. When the length of the external cavity 2 was 2 mm, it was observed that the mode of the external cavity was changed by one by causing a current of 20 mA to the external cavity 2. In addition, even when the oscillation wavelength was varied in the range of 1.5455 to 1.5465 μm with a change in the current supplied from the laser 1, it was possible to obtain the condition for continuously narrowing the line length by changing the current of the external cavity to 100 mA.

When this device was connected and operated in the same way as in Example 1, the effect the same as that of Example 1 was obtained.

In the present invention, it is also possible to obtain a similar effect by using an elecrooptic crystal of, for example, $LiTaO_3$ in place of $LiNbO_3$, and a GaAs or Si semiconductor material in place of the InP material.

## Claims

1. A semiconductor laser device comprising
   a light emitting domain (1);
   an external cavity (2) feeding back light emitted by said light emitting domain (1) to that domain (1) and being capable of changing the phase of the fed back light;
   a light receiving element (8) for receiving a part of the light emitted by said light emitting domain (1) and outputting a corresponding light output power signal; and
   a phase controlling means (9) for receiving said light output power signal and controlling the phase of said fed back light so that the light output power emitted from said light emitting domain (1) takes a predetermined value,
   characterized in
   that the light emitting domain (1) is a DFB laser.

2. The device of claim 1, wherein said phase controlling means (9) is constituted by an electric circuit.

3. The device of claim 1 or 2, wherein said phase controlling means (9) has a feedback circuit for receiving the differential signal of the light output power supplied from said light emitting domain (1) and controlling the refractive index of said external cavity (2).

4. The device of any of claims 1 to 3, wherein said light receiving element (8) is provided on said external cavity side (2).

5. The device of any of claims 1 to 4, wherein said light emitting domain (1), said external cavity (2) and said light receiving element (8) are monolithically provided.

6. The device of any of claims 1 to 5, wherein said phase controlling means (9) provides a fluctuating signal to said external cavity (2), wherein a differential signal is produced from said fluctuating signal and said light output power signal which is supplied from said light emitting domain (1) and which is varied by said fluctuating signal, and controls the phase by feeding back said differential signal to said external cavity (2), thereby varying the refractive index of said external cavity (2).

7. The device of any of claims 1 to 5, wherein said phase controlling means (9) calculates the difference between the set value of said light output power signal at which the narrowest spectrum of the laser light from said light emitting domain (1) is obtained and said light output power signal supplied from said light receiving element (8), and controls the phase by feeding back the difference signal to said external cavity (2), thereby varying the refractive index of said external cavity (2).

8. The device of claim 7, wherein said phase controlling means (9) compares said light output power signals supplied from said light emitting domain (1) when two differential signals are obtained sequentially, and controls the phase by feeding back the comparison signal to said external cavity (2), thereby varying the refractive index of said external cavity (2).

## Patentansprüche

1. Halbleiterlaser-Vorrichtung mit
   einem lichtemittierenden Bereich (1),
   einer externen Kavität (2), die von dem lichtemittierenden Bereich (1) emittiertes Licht zu diesem Bereich (1) zurückführt und in der Lage ist, die Phase des zurückgeführten Lichts zu ändern,
   einem lichtempfangenden Element (8) zum Empfangen eines Teils des von dem lichtemittierenden Bereich (1) ausgesandten Lichts und zum Ausgeben eines entsprechenden Ausgangs-Lichtleistungssignals, und
   einer Phasensteuereinrichtung (9) zum Empfang des Ausgangs-Lichtleistungssignals und zum Steuern der Phase des zurückgeführten Lichts so, daß die von dem lichtemittierenden Bereich (1) ausgesandte Ausgangs-Lichtleistung einen vorbestimmten Wert annimt,
   dadurch gekennzeichnet, daß der lichtemittierende Bereich ein DFB-Laser ist.

2. Vorrichtung nach Anspruch 1, dadurch gekennzeichnet, daß die Phasensteuereinrichtung (9) von einem elektrischen Schaltkreis gebildet ist.

3. Vorrichtung nach Anspruch 1 oder 2, dadurch gekennzeichnet, daß die Phasensteuereinrichtung (9) einen Rückkoppel-Schaltkreis zum Empfang des differenziellen Signals der von dem lichtemittierenden Bereich (1) gelieferten Ausgangs-Lichtleistung und zum Steuern des Brechungsindex der externen Kavität (2) aufweist.

4. Vorrichtung nach einem der Ansprüche 1 bis 3, dadurch gekennzeichnet, daß das lichtempfangende Element (8) auf der Seite der externen Kavität (2) angeordnet ist.

5. Vorrichtung nach einem der Ansprüche 1 bis 4, dadurch gekennzeichnet, daß der lichtemittierende Bereich (1), die externe Kavität (2) und das lichtempfangende Element (8) monolitisch sind.

6. Vorrichtung nach einem der Ansprüche 1 bis 5, dadurch gekennzeichnet, daß die Phasensteuereinrichtung (9) an die externe Kavität (2) ein schwankendes Signal anlegt, wobei von dem schwankenden Signal und dem von dem lichtemittierenden Bereich (1) gelieferten und von dem schwankenden Signal veränderten Ausgangs-Lichtleistungssignal ein differenzielles Signal erzeugt wird, und daß die Phasensteuereinrichtung (9) die Phase durch Rückführen des differenziellen Signals an die externe Kavität (2) steuert, wodurch der Brechungsindex der externen Kavität (2) verändert wird.

7. Vorrichtung nach einem der Ansprüche 1 bis 5, dadurch gekennzeichnet, daß die Phasensteuereinrichtung (9) die Differenz zwischen dem Sollwert des Ausgangs-Lichtleistungssignals, bei dem das schmalste Spektrum des Laserlichts des lichtemittierenden Bereichs (1) erhalten wird und dem von dem lichtempfangenden Element (8) gelieferten Ausgangs-Lichtleistungssignal berechnet und die Phase durch Rückführung des Differenzsignals an die externe Kavität (2) steuert, wodurch der Brechungsindex der externen Kavität (2) verändert wird.

8. Vorrichtung nach Anspruch 7, wobei die Phasensteuereinrichtung (9) die Ausgangs-Lichtleistungssignale vergleicht, die von dem lichtemittierenden Bereich geliefert werden, wenn zwei differenzielle Signale aufeinanderfolgend erhalten werden, und daß sie die Phase durch Rückführung des Vergleichssignals an die externe Kavität (2) steuert, wodurch der Brechungsindex der externen Kavität (2) verändert wird.

**Revendications**

1. Dispositif laser à semiconducteurs comprenant
   un domaine d'émission de lumière (1);
   une cavité externe (2) renvoyant la lumière émise par ledit domaine d'émission de lumière (1), à ce domaine (1) et pouvant modifier la phase de la lumière renvoyée;
   un élément de réception de lumière (8) pour recevoir une partie de la lumière émise par ledit domaine d'émission de lumière (1) et délivrer un signal de puissance lumineuse de sortie correspondant; et
   des moyens de commande de phase (9) pour recevoir ledit signal de puissance lumineuse de sortie et commander la phase de ladite lumière renvoyée de manière que la puissance lumineuse de sortie émise par ledit domaine d'émission de lumière (1) prenne une valeur prédéterminée,
   caractérisé en ce que
   que le domaine d'émission de lumière (1) est un laser DFB.

2. Dispositif selon la revendication 1, dans lequel lesdits moyens de commande de phase (9) sont constitués par un circuit électrique.

3. Dispositif selon la revendication 1 ou 2, dans lequel lesdits moyens de commande de phase (9) possèdent un circuit de réaction pour recevoir le signal différentiel de la puissance lumineuse de sortie délivrée par ledit domaine d'émission de lumière (1) et commander l'indice de réfraction de ladite cavité externe (2).

4. Dispositif selon l'une quelconque des revendications 1 à 3, dans lequel ledit élément de réception de lumière (8) est prévu sur ledit côté de la cavité externe (2).

5. Dispositif selon l'une quelconque des revendications 1 à 4, dans lequel ledit domaine d'émission de lumière (1), ladite cavité externe (2) et ledit élément de réception de lumière (8) sont réalisés sous forme monolithique.

6. Dispositif selon l'une quelconque des revendications 1 à 5, dans lequel lesdits moyens de commande de phase (9) envoient un signal fluctuant à ladite cavité externe (2), un signal différentiel étant produit à partir dudit signal fluctuant et dudit signal de puissance lumineuse de sortie, qui est délivré par ledit domaine d'émission de lumière (1), et modifié par ledit signal fluctuant, et commandent la phase par un renvoi dudit signal différentiel à ladite cavité externe (2), ce qui modifie l'indice de réfraction de ladite cavité externe (2).

7. Dispositif selon l'une quelconque des revendications 1 à 5, dans lequel lesdits moyens de commande de phase (9) calculent la différence entre la valeur réglée dudit signal de puissance lumineuse de sortie, pour laquelle le spectre le plus étroit de la lumière laser délivrée par ledit domaine d'émission de lumière (1) est obtenu, et ledit signal de puissance lumineuse de sortie délivré par ledit élément de réception de lumière (8), et commandent la phase par renvoi du signal de différence à ladite cavité externe (2), ce qui modifie l'indice de réfraction de ladite cavité externe (2).

8. Dispositif selon la revendication 7, dans lequel lesdits moyens de commande de phase (9) comparent lesdits signaux de puissance lumineuse de sortie délivrés par ledit domaine d'émission de lumière (1) lorsque deux signaux différentiels sont obtenus successivement, commandent la phase par envoi du signal de réaction à ladite cavité externe (2), ce qui modifie l'indice de réfraction de ladite cavité externe (2).

## FIG. 1

## FIG. 2

# FIG. 3

# FIG. 4

## FIG. 5(a)

## FIG. 5(b)

## FIG. 6

## FIG. 7

MEMORY

COMPARATOR

CONTROL SIGNAL

DIFFERENTIAL
AMPLIFIER

I(P)

Po

CLOCK PULSE

1 2 3

9

## FIG. 8

ΔI(P)

DIFFERENTIAL
CIRCUIT

DIFFERENTIAL SIGNAL

AMPLIFIER

FLUCTUATING
SIGNAL

9